(19) **Europäisches Patentamt**
**European Patent Office**
**Office européen des brevets**

(11) **EP 2 654 095 A1**

(12) **EUROPEAN PATENT APPLICATION**
published in accordance with Art. 153(4) EPC

(43) Date of publication:
**23.10.2013 Bulletin 2013/43**

(51) Int Cl.:
**H01L 43/08** *(2006.01)* **G01R 15/20** *(2006.01)*
**G01R 33/09** *(2006.01)*

(21) Application number: **11849636.3**

(22) Date of filing: **25.11.2011**

(86) International application number:
**PCT/JP2011/077242**

(87) International publication number:
**WO 2012/081377 (21.06.2012 Gazette 2012/25)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **16.12.2010 JP 2010280498**

(71) Applicant: **Alps Electric Co., Ltd.**
**Tokyo 145-8501 (JP)**

(72) Inventors:
• **KOIKE, Fumihito**
**Tokyo 145-8501 (JP)**

• **ASATSUMA, Kota**
**Tokyo 145-8501 (JP)**
• **SAITO, Masamichi**
**Tokyo 145-8501 (JP)**
• **TAKAHASHI, Akira**
**Tokyo 145-8501 (JP)**
• **IDE, Yosuke**
**Tokyo 145-8501 (JP)**

(74) Representative: **Klunker . Schmitt-Nilson . Hirsch**
**Patentanwälte**
**Destouchesstrasse 68**
**80796 München (DE)**

(54) **MAGNETIC SENSOR AND METHOD OF MANUFACTURING MAGNETIC SENSOR**

(57)    The present invention provides a magnetic sensor capable of decreasing dispersion of a magnetization direction of a free magnetic layer in a magnetoresistive element and having high measurement accuracy over a wide range and provides a method for manufacturing a magnetic sensor. A magnetic sensor (1) of the present invention includes a magnetoresistive element (11) having a sensitivity axis in a specified direction, the magnetoresistive element (11) having a laminated structure including a ferromagnetic pinned layer (30) having a pinned magnetization direction, a nonmagnetic intermediate layer (26), a free magnetic layer (27) having a magnetization direction varying with an external magnetic field, and an antiferromagnetic layer (28) which applies an exchange coupling magnetic field to the free magnetic layer (27).

FIG. 2

**Description**

Technical Field

The present invention relates to a magnetic sensor using a magnetoresistive element (TMR element, GMR element) and a method for manufacturing a magnetic sensor.

Background Art

In the field of motor driving technology for electric cars and hybrid cars, current sensors capable of non-contact measurement of large currents are generally required because relatively large currents are handled. Those known as the current sensors use magnetic sensors that detect an induced magnetic field from a current to be measured. Examples of magnetic detecting elements for magnetic sensors include magnetoresistive elements such as a GMR element and the like.

A GMR element has a basic layer structure including an antiferromagnetic layer, a ferromagnetic pinned layer, a nonmagnetic material layer, and a free magnetic layer. The ferromagnetic pinned layer is formed on the antiferromagnetic layer so as to be in contact with the antiferromagnetic layer and has a magnetization direction  pinned in a direction by an exchange coupling magnetic field (Hex) produced between the ferromagnetic pinned layer and the antiferromagnetic layer. The free magnetic layer is laminated with the nonmagnetic material layer (nonmagnetic intermediate layer) being held between the free magnetic layer and the ferromagnetic pinned layer and has a magnetization direction which varies according to an external magnetic field. A magnetic sensor including the GMR element detects a current value of a current to be measured based on an electric resistance value of the GMR element which varies according to a relation between the magnetization direction of the free magnetic layer, which is changed in response to an induced magnetic field applied from the current to be measured, and the magnetization direction of the ferromagnetic pinned layer.

In order to improve the measurement accuracy of the magnetic sensor, it is necessary to decrease offset, decrease variation in output signals, and improve linearity (output linearity). In order to improve linearity, it is necessary to decrease a hysteresis of the magnetoresistive element. A thin-film magnetic head proposed as an example of application of a magnetic sensor decreased in hysteresis of a magnetoresistive element includes a GMR element having a hard bias layer that applies a bias magnetic field to a free magnetic layer (refer to, for example, Patent  Literature 1).

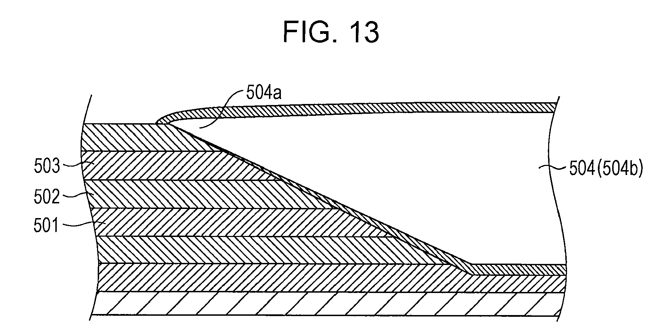

Fig. 13 is a schematic cross-sectional view showing a GMR element having a hard bias layer. As shown in Fig. 13, the GMR element includes a GMR element portion in which a pinned magnetic layer 501, a nonmagnetic material layer 502, and a free magnetic layer 503 are laminated, and a hard bias layer 504 provided adjacent to the GMR element portion. The hard bias layer 504 is composed of a highly magnetic material having high coercive force (for example, 79.6 kA/m or more) and is magnetized so as to apply a bias magnetic field in a predetermined direction. When a bias magnetic field is applied to the free magnetic layer 503 from the hard bias layer 504, unidirectional anisotropy is imparted to the magnetization direction of the free magnetic layer 503, and thus linearity (output linearity) between the electric resistance value of the GMR element and strength of an external magnetic field can be increased, thereby decreasing the hysteresis.

Citation List

Patent Literature

PTL 1: Japanese Unexamined Patent Application Publication No. 11-191647

Summary of Invention

Technical Problem

The hard bias layer 504 of the magnetoresistive element  is provided in a region in which a portion of the GMR element portion laminated on a substrate is removed by photolithography and etching. In the etching step, a boundary of the GMR element portion is inclined from a surface of the substrate by the shadowing effect of photoresist. Therefore, in the hard bias layer 504 provided in the region where the element portion is partially removed, the thickness of the hard bias layer 504 is not necessarily uniform at the ends 504a and a central portion 504b. When variation occurs in the thickness of the hard bias layer 504, a region with low coercive force (for example, 79.6 kA/m or less) is formed at each of the ends 504a of the hard bias layer 504 at which the thickness of the hard bias layer is relatively small.

When a region with low coercive force is locally present in the hard bias layer 504 as described above, the magnetization direction of the region with low coercive force in the hard bias layer 504 is dispersed by applying a strong external magnetic field in a sensitivity direction (perpendicular to the hard bias magnetic field), thereby increasing offset. Therefore, a general magnetic sensor has the problem of limiting a measurement range because with a strong magnetic field to be measured, offset is increased even when the hard bias layer is provided.

The present invention has been achieved in consideration of the above-mentioned problem, and an object of the present invention is to provide a magnetic sensor capable of decreasing dispersion of a magnetization direction of a free magnetic layer in a magnetoresistive element and having high measurement accuracy over a wide range, and to provide a method for manufacturing a magnetic sensor.

Solution to Problem

A magnetic sensor according to the present invention includes a magnetoresistive element having a sensitivity axis in a specified direction, wherein the magnetoresistive element has a laminated structure including a ferromagnetic pinned layer having a pinned magnetization direction, a nonmagnetic intermediate layer, a free magnetic layer having a magnetization direction varying according to an external magnetic field, and an antiferromagnetic layer which applies an exchange coupling magnetic field to the free magnetic layer.

In this configuration, even when a large external magnetic field is applied in the direction of the sensitivity axis of the magnetoresistive element, a predetermined exchange coupling magnetic field is applied to the free magnetic layer from the antiferromagnetic layer, and thus unidirectional anisotropy can be stably imparted to the free magnetic layer. Therefore, it is possible to decrease dispersion of the magnetization direction of the free magnetic layer in the magnetoresistive element and to realize a magnetic sensor having high measurement accuracy over a wide range.

In the magnetic sensor according to the present invention, the ferromagnetic pinned layer is a self-pinned type including a first ferromagnetic film and a second ferromagnetic film which are antiferromagnetically coupled to each other through an antiparallel coupling film, and the first ferromagnetic film and the second ferromagnetic film preferably have substantially the same Curie temperature and a difference in magnetization amount of substantially zero. In this configuration, a difference between the magnetization amount (Ms.t) of the first ferromagnetic film and the magnetization amount (Ms.t) of the second ferromagnetic film is substantially zero even in a high-temperature environment, and high magnetization stability can be maintained.

In the magnetic sensor according to the present invention, the magnetoresistive element preferably includes an element portion having a folded shape in which a plurality of stripe-shaped elongated patterns are arranged so that the longitudinal directions of stripe shapes are parallel to each other, and permanent magnet portions provided to hold the element portion therebetween. In this configuration, since a bias magnetic field is also applied to the free magnetic layer from the permanent magnet portions, unidirectional anisotropy can be imparted to the magnetization direction of the free magnetic layer particularly even in regions at both ends in the longitudinal direction of the stripe shape, where the magnetization direction is easily dispersed in the free magnetic layer. Therefore, the hysteresis of the magnetic sensor can be further decreased.

In the magnetic sensor of the present invention, the magnetoresistive element preferably includes a plurality of element portions provided apart from each other in the longitudinal direction of the stripe shape, and a plurality of permanent magnet portions provided between the element portions. In this configuration, since a strong bias magnetic field is applied to the free magnetic layer from each of the permanent magnet portions provided between the element portions, unidirectional anisotropy can be efficiently imparted to the magnetization direction of the free magnetic layer. Therefore, the hysteresis of the magnetic sensor can be particularly decreased.

In the magnetic sensor of the present invention, the ferromagnetic pinned layer preferably has a magnetization direction pinned along a direction in which an external magnetic field is applied, and the free magnetic layer is preferably magnetized in a direction substantially perpendicular to the direction in which an external magnetic field is applied.

In the magnetic sensor of the present invention, preferably, the first ferromagnetic film is composed of a CoFe alloy containing 40 atomic % to 80 atomic % of Fe, and the second ferromagnetic film is composed of a CoFe alloy containing 0 atomic % to 40 atomic % of Fe.

In the magnetic sensor of the present invention, preferably, the antiferromagnetic layer is laminated on a surface of the free magnetic layer on the side opposite to the surface on which the nonmagnetic intermediate layer is formed, and the antiferromagnetic layer is composed of an antiferromagnetic material containing element X (X is at least one element of Pt, Pd, Ir, Rh, Ru, and Os) and Mn.

A magnetic proportional current sensor of the present invention has a magnetic-field detection bridge circuit which includes at least one magnetoresistive element varying in resistance value with an induced magnetic field applied from a current to be measured and which has two outputs producing a voltage difference corresponding to the induced magnetic field, the current to be measured being measured by a voltage difference output from the magnetic-field detection bridge circuit according to the induced magnetic field. The magnetoresistive element has a laminated structure including a ferromagnetic pinned layer having the pinned magnetization direction, a nonmagnetic intermediate layer, a free magnetic layer having a magnetization direction which varies with an external magnetic field, and an antiferromagnetic layer which applies an exchange coupling magnetic field to the free magnetic layer.

In this configuration, since a predetermined exchange coupling magnetic field is applied to the free magnetic layer from the antiferromagnetic layer even when a strong external magnetic field is applied in the direction of the sensitivity axis of the magnetoresistive element, unidirectional anisotropy can be stably imparted to the free magnetic layer. Therefore, it is possible to decrease offset of the magnetoresistive element even with a large current to be measured, and to realize a magnetic proportional current sensor having high measurement accuracy over a wide range.

A magnetic balance-type current sensor of the present invention has a magnetic-field detection bridge circuit which includes at least one magnetoresistive element varying in resistance value according to an induced magnetic field applied from a current to be measured and which has two outputs producing a voltage difference corresponding to the induced magnetic field, and a feedback coil disposed near the magnetoresistive element and generating a cancel magnetic field for cancelling the induced magnetic field, the current to be measured being measured based on a current flowing through the feedback coil when a balanced state is reached in which the induced magnetic field and the cancel magnetic field are cancelled by each other electricity supplied to the feedback coil due to the voltage difference. The magnetoresistive element has a laminated structure including a ferromagnetic pinned layer having the pinned magnetization direction, a nonmagnetic intermediate layer, a free magnetic layer having a magnetization direction varying with an external magnetic field, and an antiferromagnetic layer which applies an exchange coupling magnetic field to the free magnetic layer.

In this configuration, since a predetermined exchange coupling magnetic field is applied to the free magnetic layer from the antiferromagnetic layer even when a large external magnetic field is applied in the direction of the sensitivity axis of the magnetoresistive element, unidirectional anisotropy can be stably imparted to the free magnetic layer. Therefore, it is possible to decrease offset of the magnetoresistive element even with a large current to be measured, and to realize a magnetic balance-type current sensor having high measurement accuracy over a wide range.

A method for manufacturing a magnetic sensor according to the present invention includes a first deposition step of depositing a ferromagnetic pinned layer by applying a magnetic field in a specified direction, a second deposition step of depositing a free magnetic layer and an antiferromagnetic layer by applying a magnetic field in a direction different from that in the first deposition step to form an element portion, a third deposition step of depositing a permanent magnet layer after patterning the element portion and then patterning the permanent magnet layer, a magnetization step of magnetizing the permanent magnet layer in substantially the same direction as an exchange coupling magnetic field to be applied to the free magnetic layer from the antiferromagnetic layer, and a heat treatment step of performing heat treatment at at least 200°C after magnetization of the permanent magnet layer.

According to the method, unidirectional anisotropy can be imparted to the magnetization direction of the free magnetic layer in a direction different from the magnetization direction of the pinned magnetic layer without the antiferromagnetic layer being provided for pinning the magnetization of the pinned magnetic layer. Also, the heat treatment step is performed after magnetization of the permanent magnet layer, and thus heat treatment is performed under a condition in which a bias magnetic field is applied to the free magnetic layer from the permanent magnet layer. Consequently it is possible to suppress dispersion of the exchange coupling magnetic field applied to the free magnetic layer from the antiferromagnetic layer and to impart unidirectional anisotropy to the magnetization direction of the free magnetic layer by both the bias magnetic field from the permanent magnet layer and the exchange coupling magnetic field from the antiferromagnetic field.

Advantageous Effects of Invention

According to the present invention, it is possible to provide a magnetic sensor capable of decreasing dispersion of the magnetization direction of a free magnetic layer in a magnetoresistive element and exhibiting high measurement accuracy over a wide range, and also provide a method for manufacturing a magnetic sensor.

Brief Description of Drawings

[Fig. 1] Fig. 1 is a schematic plan view showing an element structure of a magnetoresistive element of a magnetic sensor according to a first embodiment of the present invention.
[Fig. 2] Fig. 2 is a schematic cross-sectional view showing a laminated structure of the magnetoresistive element according to the first embodiment of the present invention.
[Fig. 3] Fig. 3 is a schematic plan view showing an example of an element structure of the magnetoresistive element according to the first embodiment of the present invention.
[Fig. 4] Fig. 4 is a schematic plan view showing another example of an element structure of the magnetoresistive element according to the first embodiment of the present invention.

[Fig. 5] Fig. 5 is a schematic cross-sectional view showing a laminated structure in the other example of an element structure of the magnetoresistive element according to the first embodiment of the present invention.

[Fig. 6] Fig. 6 is a graph showing a relation between a hard bias magnetic field and an exchange coupling magnetic field from an antiferromagnetic layer in an element portion of the magnetoresistive element according to the first embodiment of the present invention.

[Fig. 7] Fig. 7 is a drawing showing a residual magnetic flux density (remanence) in the magnetoresistive element of the magnetic sensor according to the first embodiment of the present invention.

[Fig. 8] Fig. 8 is an explanatory view of a definition of remanence in the magnetic sensor according to the first embodiment of the present invention.

[Fig. 9] Fig. 9 is a graph showing a relation between the thickness of a free magnetic layer and detection sensitivity of the magnetoresistive element of the magnetic sensor according to the first embodiment of the present invention.

[Fig. 10] Fig. 10 is a graph showing a relation between the hard bias layer interval L1 and remanence in the magnetoresistive element of the magnetic sensor according to the first embodiment of the present invention.

[Fig. 11] Fig. 11 is a schematic perspective view of a magnetic balance-type current sensor according to a second embodiment of the present invention.

[Fig. 12] Fig. 12 is a schematic plan view of the magnetic balance-type current sensor according to the second embodiment of the present invention.

[Fig. 13] Fig. 13 is a schematic cross-sectional view of a GMR element provided with a hard bias layer.

Description of Embodiments

In order to further improve measurement accuracy of a magnetic sensor provided with a magnetoresistive element, it is necessary to decrease offset and hysteresis of the magnetoresistive element. In a magnetic sensor provided with a magnetoresistive element, hysteresis can be decreased by providing a hard bias layer to impart unidirectional anisotropy to a free magnetic layer. On the other hand, when the hard bias layer is provided, there is a problem that with a strong external magnetic field applied, the magnetization direction of the hard bias layer is dispersed due to variation in coercive force in the hard bias layer without being retuned to an initial state. Therefore, when a magnetic sensor is used in an environment of strong magnetic field strength, a bias magnetic field (hereinafter referred to as a "hard bias magnetic field") from the hard bias layer is dispersed, thereby causing the problem of failing to sufficiently decrease the offset of the magnetic sensor.

Also, in the magnetoresistive element including the hard bias layer, the strength of the magnetic field applied to the free magnetic layer from the hard bias layer is increased in the free magnetic layer within a region near the hard bias layer. On the other hand, the strength of the magnetic field applied to the free magnetic layer from the hard bias layer is decreased in the free magnetic layer within a region apart from the hard bias layer. Therefore, it is difficult to impart unidirectional anisotropy to the free magnetic layer, thereby causing the problem of increasing hysteresis.

The inventors of the present invention paid attention to the fact that in a magnetic sensor provided with a magnetoresistive element, unidirectional anisotropy can be imparted to the magnetization direction of a free magnetic layer by an exchange coupling magnetic field between the free magnetic layer and an antiferromagnetic layer. As a result, the inventors of the present invention found that even when a large magnetic field is applied in a sensitivity axis direction, unidirectional anisotropy can be stably imparted to the free magnetic layer without dispersion of the exchange coupling magnetic field, leading to the achievement of the present invention.

Also, the inventors of the present invention found that when the exchange coupling magnetic field between the free magnetic layer and the antiferromagnetic layer is used, even in the magnetoresistive element having a stripe element shape, unidirectional anisotropy can be stably imparted to the ends of the free magnetic layer in the longitudinal direction of the stripe shape, and particularly, the hysteresis of the magnetoresistive element can be decreased by further providing the hard bias layers.

Embodiments of the present invention are described in detail below with reference to the attached drawings.

(First Embodiment)

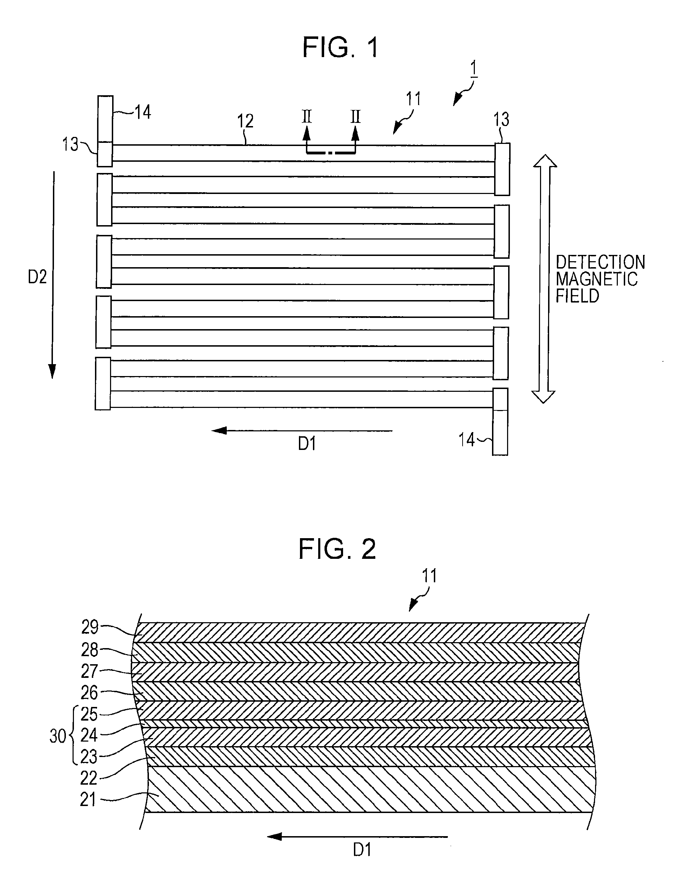

Fig. 1 is a schematic plan view showing an element structure of a magnetoresistive element 11 of a magnetic sensor 1 according to a first embodiment of the present invention. As shown in Fig. 1, the magnetic sensor 1 according to the embodiment has the stripe-shaped magnetoresistive element 11. The magnetoresistive element 11 has a folded shape (meandering shape) in which a plurality of stripe-shaped elongated patterns 12 (stripes) are arranged so that stripe longitudinal directions D1 (hereinafter simply referred to as "longitudinal direction D1") are parallel to each other. In the meandering shape, a sensitivity axis direction (Pin direction) is a direction (stripe width direction D2) perpendicular to the longitudinal direction (stripe longitudinal direction D1) of the elongated patterns 12. In the meandering shape, a detection magnetic field and a cancel magnetic field are applied along the stripe width direction D2 perpendicular to the stripe longitudinal direction D1.

The two adjacent elongated patterns 12 are connected, at both ends of each of the elongated patterns 12, through nonmagnetic layers 13 in the stripe width direction D2 (hereinafter simply referred to as the "width direction D2") perpendicular to the longitudinal directions D1 of the elongated patterns 12. The nonmagnetic layers 13 are provided to connect the respective elongated patterns 12 at both ends. That is, of the plurality of elongated patterns 12 arranged in parallel, the first elongated pattern 12 and the second elongated pattern 12 from the top are connected through the nonmagnetic layer 13 at one (end on the right) of the ends in the longitudinal directions D1, and the second elongated pattern 12 and the third elongated pattern 12 from the top are connected through the nonmagnetic layer 13 at the other end (end on the left) in the longitudinal directions D1. Each two adjacent elongated patterns 12 are connected to each other through the nonmagnetic layer 13 alternately at one and the other ends.

Connecting terminals 14 are connected to both ends of the magnetoresistive element 11 through the nonmagnetic layer 13. The connecting terminals 14 are connected to an arithmetic unit (not shown) which calculates the magnitude of a current to be measured from output signals of the magnetoresistive element 11. The magnetoresistive element 11 outputs the output signals to the arithmetic unit (not shown) through the connecting terminals 14.

Fig. 2 is a schematic cross-sectional view showing a laminated structure of the magnetoresistive element 11 of the magnetic sensor 1 according to the first embodiment. Fig. 2 shows a section taken along arrow line II-II in Fig. 1.

As shown in Fig. 2, the magnetoresistive element 11 is laminated on an aluminum oxide film 21 provided on a substrate (not shown) such as a silicon substrate. The magnetoresistive element 11 includes a seed layer 22, a first ferromagnetic film 23, an antiparallel coupling film 24, a second ferromagnetic film 25, a nonmagnetic intermediate layer 26, a free magnetic layer 27, an antiferromagnetic layer 28, and a protective layer 29 which are laminated in that order.

The seed layer 22 is composed of NiFeCr or Cr. The protective layer 29 is composed of Ta. In the laminated structure, an underlying layer composed of a nonmagnetic material, for example, at least one element of Ta, Hf, Nb, Zr, Ti, Mo, and W, may be provided between the substrate (not shown) and the seed layer 22.

In the magnetoresistive element 11, the first ferromagnetic film 23 and the second ferromagnetic film 25 are antiferromagnetically coupled to each other through the antiparallel coupling film 24 to form a so- called self- pinned ferromagnetic pinned layer 30 (SFP: Synthetic Ferri Pinned layer) . By forming the self- pinned (Bottom- Spin- Value) magnetoresistive element 11, annealing in a magnetic field for pinning the magnetization direction of the ferromagnetic pinned layer 30, which is essential for a usual magnetoresistive element, is not required, and induced magnetic anisotropy in the stripe longitudinal direction D1 which is imparted during deposition of the free magnetic layer 27, can be maintained. This permits a decrease in hysteresis in the detection direction (stripe width direction D2) .

In the ferromagnetic pinned layer 30, when the thickness of the antiparallel coupling film 24 is 0.3 nm to 0.45 nm or 0.75 nm to 0.95 nm, strong antiferromagnetic coupling can be caused between the first ferromagnetic film 23 and the second ferromagnetic film 25.

The magnetization amount (Ms.t) of the first ferromagnetic film 23 and the magnetization amount (Ms.t) of the second ferromagnetic film 25 are substantially the same. That is, a difference in magnetization amount between the first ferromagnetic film 23 and the second ferromagnetic film 25 is substantially zero. This allows the ferromagnetic pinned layer to have a large effective anisotropy field. Therefore, magnetization stability of the ferromagnetic pinned layer 30 can be sufficiently secured without using an antiferromagnetic material. This is because the effective anisotropy field of a SFP layer is represented by relational expression (1) below, wherein $t_1$ is the thickness of the first ferromagnetic film 23, $t_2$ is the thickness of the second ferromagnetic film 25, and Ms and K represent magnetization and induced magnetic anisotropy constant, respectively, per unit volume of each of the layers.

Expression (1)

$$eff\ Hk = 2(K.t_1 + k.t_2)/(Ms.t_1 - Ms.t_2)$$

The Curie temperature (Tc) of the first ferromagnetic film 23 and the Curie temperature (Tc) of the second ferromagnetic film 25 are substantially the same. This makes a difference in magnetization amount (Ms.t) between the first ferromagnetic film 23 and the second ferromagnetic film 25 substantially zero even in a high-temperature environment, and high magnetization stability can be maintained.

The first ferromagnetic film 23 is preferably composed of a CoFe alloy containing 40 atomic % to 80 atomic % of Fe. This is because a CoFe alloy having this composition range has large coercive force and can stably maintain magnetization against an external magnetic field. The second ferromagnetic film 25 is preferably composed of a CoFe alloy containing 0 atomic % to 40 atomic % of Fe. This is because a CoFe alloy having this composition range has small coercive force and is easily magnetized in a direction antiparallel (direction 180° different) with a direction in which the first ferromagnetic film 23 is preferentially magnetized. As a result, Hk represented by the above relational expression (1) can be increased. Also, since the composition of the second ferromagnetic film 25 is limited to this range, a rate of change in resistance of the magnetoresistive element 11 can be increased.

During deposition of the first ferromagnetic film 23 and the second ferromagnetic film 25, it is preferred to apply a magnetic field in the stripe width direction D2 of the meandering shape to impart induced magnetic anisotropy to the first ferromagnetic film 23 and the second ferromagnetic film 25 after deposition. As a result, the first ferromagnetic film 23 and the second ferromagnetic film 25 are magnetized in antiparallel in the stripe width direction D2. Since the magnetization directions of the first ferromagnetic film 23 and the second ferromagnetic film 25 are determined by the direction in which the magnetic field is applied during deposition of the first ferromagnetic film 23, a plurality of magnetoresistive elements 11 including ferromagnetic pinned layers 30 having different magnetization directions can be formed on the same substrate by changing the direction in which the magnetic field is applied during deposition of the first ferromagnetic film 23.

The antiparallel coupling film 24 of the ferromagnetic pinned layer 30 is composed of Ru or the like. The free magnetic layer (free layer) 27 is composed of a magnetic material such as a CoFe alloy, a NiFe alloy, a CoFeNi alloy, or the like. The nonmagnetic intermediate layer 26 is composed of Cu or the like. In addition, it is preferred to apply a magnetic field in the stripe longitudinal direction D1 of the meandering shape during deposition of the free magnetic layer 27 to impart induced magnetic anisotropy to the free magnetic layer 27 after deposition. This allows linear change in resistance of the magnetoresistive element with an external magnetic field (magnetic field from the current to be measured) in the stripe width direction D2, thereby decreasing the hysteresis. The magnetoresistive element has a spin-valve configuration constituted by the ferromagnetic pinned layer 30, the nonmagnetic intermediate layer 26, and the free magnetic layer 27.

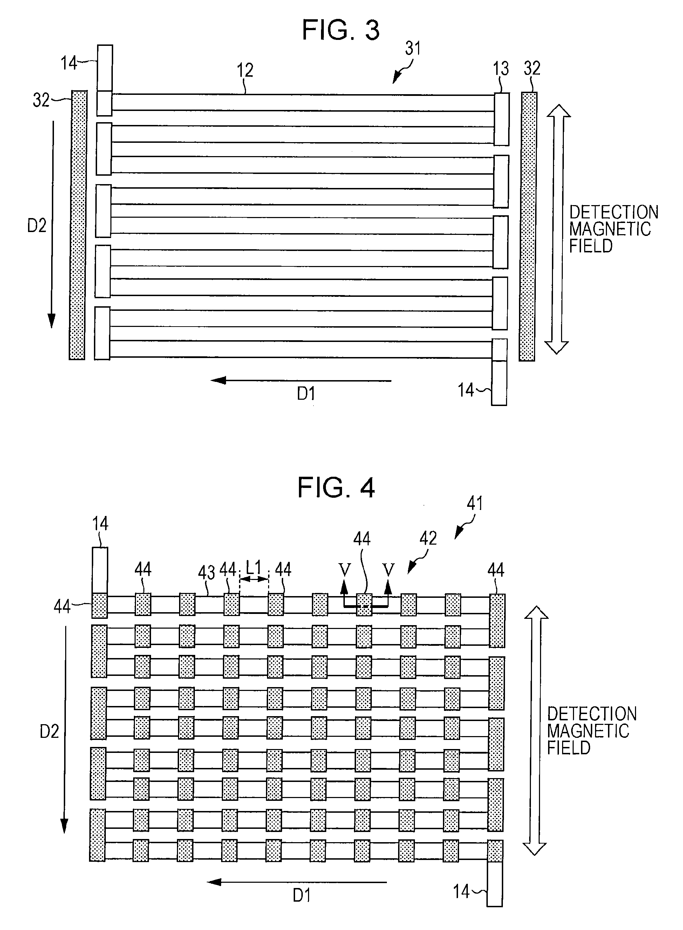

In the magnetic sensor according to this embodiment, the antiferromagnetic layer 28 is laminated on the free magnetic layer 27 of the magnetoresistive element 11. The antiferromagnetic layer 28 produces an exchange coupling magnetic field (Hex) at an interface between the antiferromagnetic layer 28 and the free magnetic layer 27 when heat-treated (hereinafter referred to as "annealing") in a magnetic field. The exchange coupling magnetic field imparts unidirectional anisotropy to the magnetization direction of the free magnetic layer 27. In an example shown in Fig. 4, the magnetization direction of the free magnetic layer 27 is pinned in the direction D2 substantially perpendicular to the direction D1 of the applied magnetic field in a plan view. The strength of the exchange coupling magnetic field applied to the free magnetic layer 27 from the antiferromagnetic layer 28 is adjusted so that the magnetization direction of the free magnetic layer 27 varies with an external magnetic field.

The antiferromagnetic layer 28 is laminated on a surface of the free magnetic layer 27 opposite to the main surface on which the nonmagnetic intermediate layer 26 is formed. The antiferromagnetic layer 28 is composed of an antiferromagnetic material containing Mn and at least one element selected from the group consisting of Pt, Pd, Ir, Rh, Ru, and Os, or an antiferromagnetic material containing Mn, at least one element selected from the group consisting of Pt, Pd, Ir, Rh, Ru, and Os, and at least one element selected from Ne, Ar, Kr, Xe, Be, B, C, N, Mg, A1, Si, P, Ti, V, Cr, Fe, Co, Ni, Cu, Zn, Ga, Ge, Zr, Nb, Mo, Ag, Cd, Sn, Hf, Ta, W, Re, Au, Pb, and the rare earth elements. Among these antiferromagnetic materials, the antiferromagnetic layer 28 is preferably composed of the antiferromagnetic material containing Mn and element X (X is at least one element of Pt, Pd, Ir, Rh, Ru, and Os), and IrMn and PtMn are more preferably used.

An example of a film configuration of the magnetoresistive element 11 used in the magnetic sensor 1 according to this embodiment is NiFeCr (seed layer 22: 5 nm) /$Fe_{60}C_{40}$ (first ferromagnetic film 23: 1.65 nm) /Ru (antiparallel coupling film 24: 0.4 nm) /$Co_{90}Fe_{10}$ (second ferromagnetic film 25: 2 nm) /Cu (nonmagnetic intermediate layer 26: 2.2 nm) /$Co_{90}Fe_{10}$ (free magnetic layer 27: 1 nm) /$Ni_{81}Fe_{19}$ (free magnetic layer 27: 7 nm) / IrMn (antiferromagnetic layer 28: 10 nm) /Ta (protective layer 29: 5 nm) .

Next, other examples of the configuration of the magnetoresistive element of the magnetic sensor according to the embodiment are described with reference to Figs. 3 to 5. Hereinafter, the same constituent element as in the magnetoresistive element 122a shown in Fig. 1 is denoted by the same reference numeral. Also, description is mainly made of a difference from the magnetoresistive element 122a shown in Figs. 1 and 2, and duplicated description is avoided.

Fig. 3 is a schematic plan view showing an example of an element structure of the magnetoresistive element. As shown in Fig. 3, a magnetoresistive element 31 includes permanent magnet portions 32 having hard bias layers provided outsides both ends of stripe-shaped elongated patterns 12. By providing the permanent magnet portions 32, in addition to an exchange coupling magnetic field applied to the free magnetic layer 27 from the antiferromagnetic layer 28, a hard bias magnetic field is applied to the free magnetic layer 27 from the hard bias layers 51 of the permanent magnet portions 32, thereby permitting efficient initialization of the magnetization direction of the free magnetic layer 27.

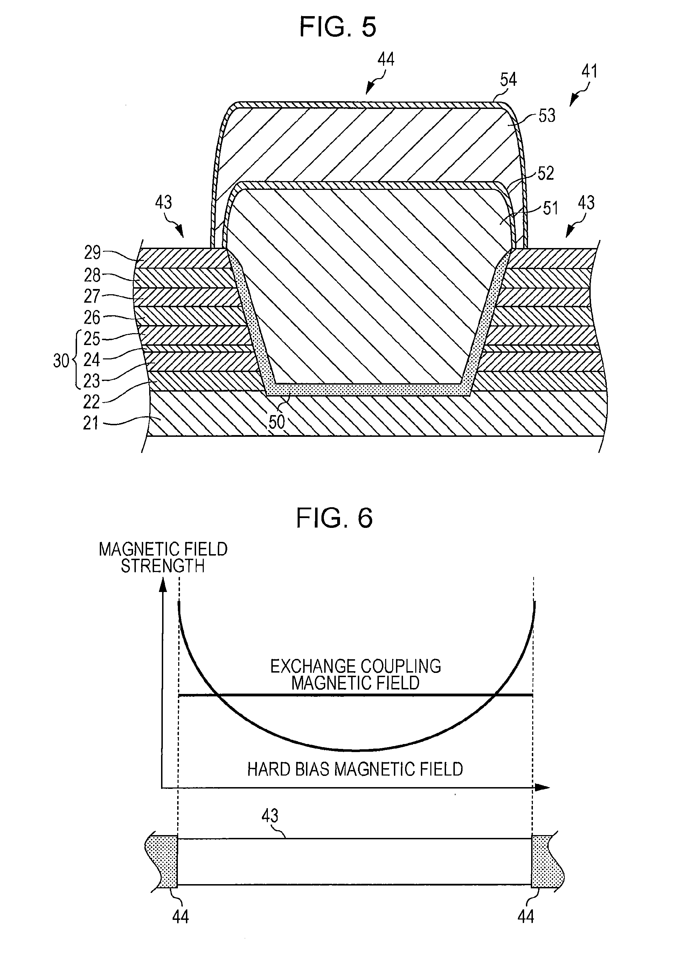

Fig. 4 is a schematic plan view showing another example of an element structure of the magnetoresistive element. As shown in Fig. 4, a magnetoresistive element 41 has a plurality of stripe-shaped elongated patterns 42 arranged so that the stripe longitudinal directions D1 are parallel to each other. Each of the elongated patterns 42 has a plurality of element portions 43 provided apart from each other in the stripe longitudinal direction D1, and a plurality of permanent magnet portions 44 provided between the respective element portions 43. In addition, the elongated patterns 42 are connected, at both ends, through permanent magnet portions 44 in the stripe width direction D2. The permanent magnet portions 44 are provided so that the hard bias layers (refer to Fig. 5) are provided at predetermined interval L1 in the stripe longitudinal direction D1 of the elongated patterns 42. In this way, a plurality of element portions 43 are provided apart from each other in the stripe longitudinal direction D1 of the magnetoresistive element 41, and the permanent magnet portions 44 are provided between the element portions 43. As a result, in addition to an exchange coupling magnetic field applied to the free magnetic layer 27 from the antiferromagnetic layer 28, a hard bias magnetic field is applied to the free magnetic layer 27 of each of the element portions 43 from the hard bias layer 51 of each of the permanent magnet portions 44, thereby permitting efficient initialization of the magnetization direction of the free magnetic layer 27.

Next, the laminated structure of the magnetoresistive element 41 is described with reference to Fig. 5. Fig. 5 is a schematic cross-sectional view showing the laminated structure of the magnetoresistive element 41. Fig. 5 shows a section taken along arrow line V-V in Fig. 4. As shown in Fig. 5, the element portions 43 and the permanent magnet portions 44 of the magnetoresistive element 41 are laminated on an aluminum oxide film 21 provided on a substrate such as a silicon substrate (not shown). The element portions 43 are provided apart from each other at a predetermined interval, and the permanent magnet portions 44 are provided between the element portions 43. The laminated structure of the element portions 43 is the same as the magnetoresistive element 11 shown in Fig. 2, and thus description is avoided.

Next, the laminated structure of the permanent magnet portions 44 is described. Each of the permanent magnet portions 44 is provided in a region in which a portion of the element portions 43 provided to cover the aluminum oxide film 21 is removed by etching.

Each of the permanent magnet portions 44 has an under layer 50 provided on the aluminum oxide film 21 and the element portions 43, the hard bias layer 51 provided on the under layer 50, an anti-diffusion layer 52 provided on the hard bias layer 51, an electrode layer 53 provided on the anti-diffusion layer 52, and a protective layer 54 provided on the electrode layer 53. The permanent magnet portions 32 of the magnetoresistive element 31 shown in Fig. 3 have the same laminated structure.

The under layer 50 is composed of an alloy containing Ta/CrTi or the like. The under layer 50 is provided in a region containing a contact portion between the hard bias layer 51 and the free magnetic layer 27 of each element portion 43 to decrease the hard bias magnetic field applied to the free magnetic layer 27 of each element portion 43 from the hard bias layer 51. By providing the under layer 50, the hard bias layer 51 is not in direct contact with the free magnetic layer 27, thereby suppressing fixing of the magnetization direction of the free magnetic layer 27 at a portion of contact with the hard bias layer 51 and reducing a dead area of the free magnetic layer 27. As a result, hysteresis can be decreased. Also, by providing the under layer 50, coercive force of the hard bias layer 51 can be enhanced.

The hard bias layer 51 is composed of, for example, CoPt, CoCrPt, or the like, and applies the hard bias magnetic field to the free magnetic layer 27 of each of the element portions 43. Each of the permanent magnet portions 44 is laminated so that the lower surface of the hard bias layer 51 is at a height position (height position lower than the lower surface of the seed layer 22) corresponding to an intermediate position in the aluminum oxide film 21 of each element portion 43 and the upper surface of the hard bias layer 51 is at a height position higher than the upper surface of the protective layer 29 of each element portion 43. By providing the hard bias layer 51 to cover a region including the side surfaces of the free magnetic layer 27, the hard bias magnetic field can be applied in a direction substantially perpendicular to the sensitivity axis direction of the free magnetic layer 27. Therefore, hysteresis can be effectively decreased.

The anti-diffusion layer 52 is composed of Ta or the like and is provided to cover the hard bias layer 51. The electrode layer 53 is composed of Au, A1, Cu, Cr, or the like and is provided to cover the anti-diffusion layer 52. Also, the electrode layer 53 is provided to be in contact with the protective layers 29 of the element portions 43 provided to hold each permanent magnet portion 44 therebetween and to electrically connect the element portions 43 provided to hold each permanent magnet portion 44 therebetween. The protective layer 54 is composed of Ta or the like.

In the magnetoresistive element 41, the electrode layer 53 is provided in each of the permanent magnet portions 44 to electrically connect the adjacent element portions 43 through the electrode layer 53, and thus output signals are output from the magnetoresistive element 41 through the electrode layers 53. Since output signals are output from the magnetoresistive element 41 through the electrode layers 53, it is possible to decrease the influence of parasitic resistance by the hard bias layer 51 of each of the permanent magnet portions 44 having the pinned magnetization direction and to suppress variation in element resistance.

The interval L1 between the hard bias layers 51 in the longitudinal direction D1 of the magnetoresistive element 41 is preferably 1 μm to 50 μm. When the interval L1 between the hard bias layers 51 is preferably 1 μm to 50 μm, the hysteresis of the magnetoresistive element 41 can be decreased.

The stripe width in the sensitivity axis direction (stripe width direction D2) of the magnetoresistive element 41 is preferably in a range of 2 μm to 9 μm. With the stripe width in the range of 2 μm to 9 μm, the hysteresis is decreased, and linearity of an output signal of the magnetoresistive element 41 is improved. In view of linearity in the magnetoresistive element 41, the longitudinal direction D1 of the elongated patterns 42 is preferably perpendicular to both the direction of induced magnetic field H and the direction of cancel magnetic field.

The hard bias magnetic field applied to the free magnetic layer 27 from each of the hard bias layers 51 and the exchange coupling magnetic field applied to the free magnetic layer 27 from the antiferromagnetic layer 28 in the magnetoresistive element 41 are described with reference to Fig. 6. Fig. 6 is a graph showing a relation between the hard bias magnetic field and the exchange coupling magnetic field from the antiferromagnetic layer 28 in each element portion 43 of the magnetoresistive element 41.

Fig. 6 indicates that the magnetic-field strength of the hard bias magnetic field in each element portion 43 is maximized at the contact portions with the permanent magnet portions 44 and decreases according to the distance from each of the permanent magnet portions 44. The exchange coupling magnetic field is substantially constant in each of the element portions 43 regardless of the distance from the permanent magnet portions 44. This result reveals that in the magnetic sensor 1 according to the embodiment, when the exchange coupling magnetic field is applied to the free magnetic layer 27 from the antiferromagnetic layer 28, unidirectional anisotropy can be stably imparted to the free magnetic layer 27 regardless of the distance from the permanent magnet portions 44. Further, when the hard bias magnetic field from the hard bias layer 51 is used in combination with the exchange coupling magnetic field, at both ends in the stripe longitudinal direction D1 at which the magnetization direction of the free magnetic layer 27 is easily dispersed, appropriate unidirectional anisotropy can be imparted to the magnetization direction of the free magnetic layer 27 even in the case of the weak exchange coupling magnetic field applied to the free magnetic layer 27. Therefore, the detection sensitivity of the magnetic sensor 1 can be improved.

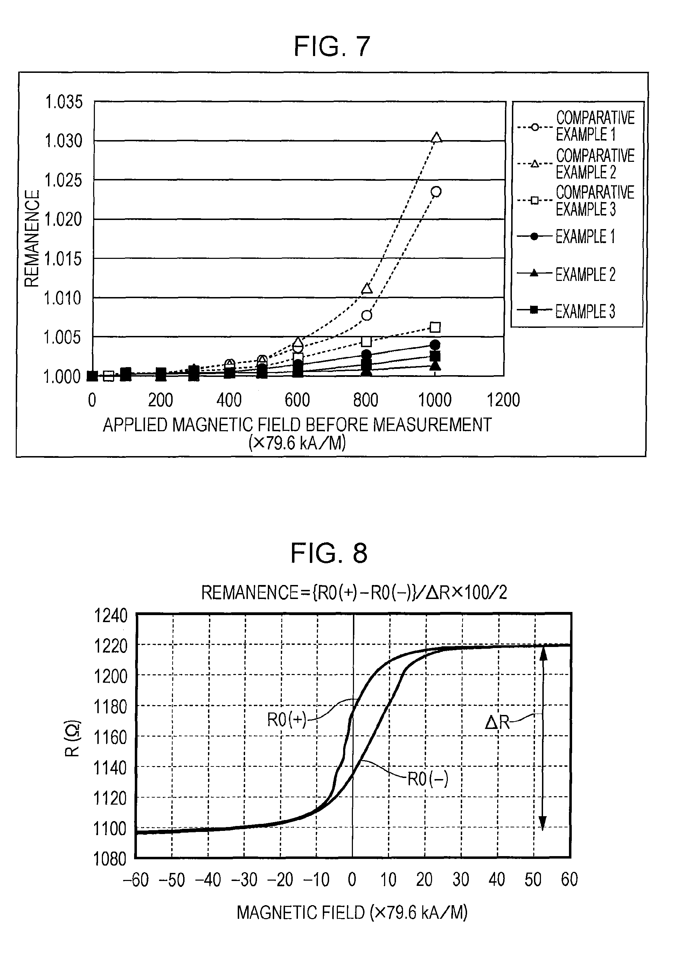

The inventors of the present invention examined residual magnetic flux density (remanence) in each of the magnetoresistive elements 11 (Example 1), 31 (Example 2), and 41 (Example 3) of the magnetic sensor 1 according to the embodiment. The results are shown in Fig. 7. Also, as comparative examples, remanence was examined in a magnetoresistive element (Comparative Example 1) in which the antiferromagnetic layer 28 was removed from the magnetoresistive element 31, a magnetoresistive element (Comparative Example 2) in which the antiferromagnetic layer 28 was removed from the magnetoresistive element 41, and a magnetoresistive element (Comparative Example 3) in which the antiferromagnetic layer 28 was removed from the magnetoresistive element 41, and an antiferromagnetic portion was provided in place of the permanent magnet portions 44. The results are also shown in Fig. 7. The measurement results shown in Fig. 7 show the remanence measured by sequentially performing romance measurement, application of a magnetic field from the same direction as an sensitivity axis, romance measurement, application of a magnetic field in a direction opposite to the sensitivity axis, and remanence measurement. As shown in Fig. 8, the remanence is represented by a ratio of a value obtained by subtracting a resistance value (RO(-)) from a resistance value (RO(+)) to a resistance value difference ($\Delta R$) of the magnetoresistive element 1, 31, or 41, the resistance value (RO(-)) being measured by returning to zero magnetic field from a minus magnetic field, and the resistance value (RO(+)) being measured by returning to zero magnetic field from a plus magnetic field.

Fig. 7 indicates that in the magnetoresistive elements 11, 31, and 41 each having the antiferromagnetic layer 28, the remanence is small with any applied magnetic field strength within a range of 0 A/M to 79.6 kA/M. On the other hand, in the magnetoresistive elements of Comparative Examples 1 and Comparative Example 2 without the antiferromagnetic layer, the romance significantly increases as the magnetic-field strength increases. In particular, it is found that with 79.6 kA/M, the romance is increased 4 times or more as compared with the magnetoresistive elements 11, 31, and 41 of Example 1 to Example 3. It is also found that in the magnetoresistive element of Comparative Example 3 having the antiferromagnetic portion provided in place of the permanent magnet portions 44, the romance is increased as compared with the magnetoresistive elements 11, 31, 41 of Example 1 to Example 3.

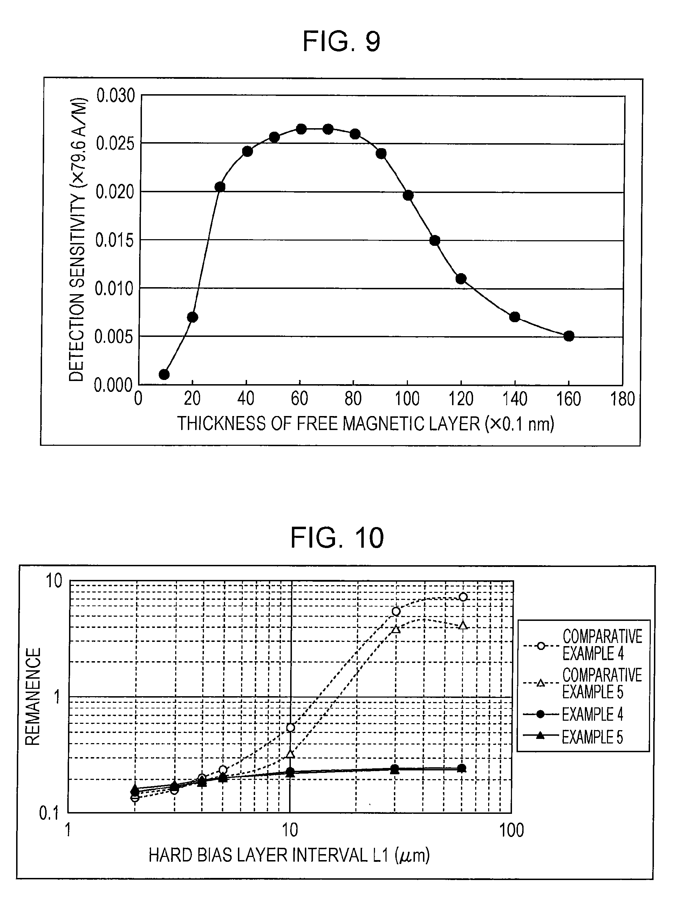

Next, the inventors examined a relation between the thickness of the free magnetic layer 27 and detection sensitivity of each of the magnetoresistive elements 11, 31, and 41. The results are shown in Fig. 9. Fig. 9 shows the detection sensitivity of the magnetoresistive element in an example in which the thickness in the magnetoresistive element 11, 31, or 41 was changed in a range of 1 nm to 160 nm.

Fig. 9 indicates that in the magnetoresistive element 11, 31, or 41, good detection sensitivity is obtained with the free magnetic layer 27 having a thickness in a range of 2 nm to 160 nm. It is also found that the detection sensitivity is particularly good with the free magnetic layer 27 having a thickness in a range of 3 nm to 10 nm.

Next, the inventors of the present invention examined a relation between the interval L1 between the hard bias layers 51 and remanence in the magnetoresistive element 41 in the case of the free magnetic layer 27 having a thickness of each of 2 nm (Example 4) and 3 nm (Example 5) . The results are shown in Fig. 10. Also, the inventors examined remanence in the magnetoresistive element 41 without the antiferromagnetic layer 28 in the case of the free magnetic layer 27 having a thickness of each of 2 nm (Comparative Example 4) and 3 nm (Comparative Example 5) . The results are also shown in Fig. 10.

Fig. 10 indicates that in the magnetoresistive elements 41 of Example 4 and Example 5 each including the antiferromagnetic layer 28 provided over the entire surface, the remanence is substantially constant with the interval L1 in a range of 2 $\mu$m to 60 $\mu$m between the hard bias layers 51. On the other hand, it is found that in the magnetoresistive elements of Comparative Example 4 and Comparative Example 5 without the antiferromagnetic layer 28, the remanence is significantly increased with the interval L1 of 10 μm or more between the hard bias layers 51. This result reveals that in the magnetoresistive element 41, the remanence can be significantly decreased by providing the antiferromagnetic layer 28 regardless of the interval between the hard bias layers 51.

Next, a method for manufacturing the magnetic sensor according to the embodiment is described. The method for manufacturing the magnetic sensor according to the embodiment includes depositing the pinned magnetic layer by applying a magnetic field in a specified direction (first deposition step), and depositing the free magnetic layer 27 and the antiferromagnetic layer 28 by applying a magnetic field in a direction different from that in the first deposition step to form the element portions 43 (second deposition step) . Next, the element portions are patterned into a stripe shape, and then the permanent magnet portions 44 are formed and patterned (third deposition step) . Next, the hard bias layers are magnetized by applying a magnetic field in a direction substantially the same as the magnetization direction of the antiferromagnetic layer 28 (magnetization step), and the magnetized hard bias layers are heat-treated at at least 200°C (heat treatment step) .

In the first deposition step, the aluminum oxide film 21, the seed layer 22, and the pinned magnetic layer 30 (the first ferromagnetic film 23, the antiparallel coupling film 24, and the second ferromagnetic film 25) are sequentially deposited on the silicon substrate. In the first deposition step, a magnetic field is applied in the stripe width direction D2 of the meandering shape during deposition of the first ferromagnetic film 23 and the second ferromagnetic film 25. The directions of the magnetic field applied during deposition of the first ferromagnetic film 23 and the second ferromagnetic film 25 may be the same direction or opposite directions. Also, the magnetic field may be applied during deposition of the first ferromagnetic film 23, while the second ferromagnetic film 25 may be deposited with no magnetic field. This is because the magnetization direction is necessarily determined to a direction opposite to that of the first ferromagnetic film 23 by virtue of exchange coupling through the antiparallel coupling film 24. In this case, it is important to optimize the thickness of the antiparallel coupling film 24 and cause the Ms.t values of the first ferromagnetic film 23 and the second ferromagnetic film 25 to coincide with each other.

In the second deposition step, the nonmagnetic intermediate layer 26, the free magnetic layer 27, the antiferromagnetic layer 28, and the protective layer 29 are sequentially formed. In the second deposition step, a magnetic field is applied in the stripe longitudinal direction D1 of the meandering shape during deposition of the free magnetic layer 27.

In the third deposition step, a resist layer is provided on the protective layer 29, and the element portion 43 is patterned into a stripe shape. Patterning of the resist layer is performed by exposure and development. In the element portion 43, regions other than regions covered with the resist layer are removed by dry etching, such as ion milling or the like, to pattern the element portion 43 into a stripe shape.

Also, in the third deposition step, a resist layer is provided on the protective layer 29 and then patterned to form regions where the permanent magnet portions 44 are to be formed in the element portions 43. Patterning of the resist layer is performed by exposure and development. Next, in the element portion 43, regions other than regions covered with the resist layer are removed by dry etching, such as ion milling or the like, to form the permanent magnet portions 44. Next, the resist layer is removed to form a pattern of the permanent magnet portions 44.

In the first deposition step, the second deposition step, and the third deposition step, a sputtering method or a vapor deposition method is used as a deposition method. As the sputtering method, a DC magnetron sputtering method, a RF sputtering method, an ion beam sputtering method, a long-throw sputtering method, a collimation sputtering method, and the like can be used.

Next, in the magnetization step, the hard bias layers 51 are magnetized in the magnetization direction of the free magnetic layer 27. Magnetization of the hard bias layers 51 is performed at room temperature by applying, using a magnetic generator, a magnetic field of about 240 kA/m or more in the direction in which the unidirectional anisotropy is applied to the free magnetic layer. In the magnetization step, the unidirectional anisotropy can be imparted to the free magnetic layer 27 substantially along the magnetization direction of the hard bias layers 51.

Also, in the magnetization step, annealing is performed in a magnetic field to generate an exchange coupling magnetic field between the antiferromagnetic layer 28 and the free magnetic layer 27, thereby imparting unidirectional anisotropy in the stripe width direction D2 to the magnetization direction of the free magnetic layer 27. The temperature of annealing is, for example, about 270°C, and the magnitude of the applied magnetic field is about 800 kA/m. In addition, the annealing time is, for example, 1.5 hours.

Finally, in the heat treatment step, the magnetized hard bias layers 51 are heated to 200°C or more to perform reflowing. The magnetic sensor can be manufactured by these steps. In the heat treatment step, the free magnetic layer 27 and the antiferromagnetic layer 28 are heated with the hard bias magnetic field applied from the hard bias layers 51, and thus deterioration in the exchange coupling magnetic field between the antiferromagnetic layer 28 and the free magnetic layer 27 can be suppressed. As a result, an increase in offset accompanying dispersion of the magnetic direction of the free magnetic layer 27 can be suppressed.

As described above, the magnetic sensor according to the above-described embodiment includes the magnetoresistive element having the free magnetic layer having a magnetization direction which varies with an external magnetic field and the antiferromagnetic layer which applies an exchange coupling magnetic field to the free magnetic layer. Thus, even when a large external magnetic field is applied in the sensitivity axis direction of the magnetoresistive element, unidirectional anisotropy can be stably imparted to the free magnetic layer because a predetermined exchange coupling magnetic field is applied to the free magnetic layer from the antiferromagnetic layer. Therefore, it is possible to realize a magnetic sensor capable of decreasing dispersion of the magnetization direction of the free magnetic layer in the magnetoresistive element and having high measurement accuracy over a wide range.

In the magnetic sensor according to the above-described embodiment, even when the element shape of the magnetoresistive element which easily causes dispersion of the magnetization direction of the free magnetic layer is a stripe shape, the exchange coupling magnetic field is substantially uniformly applied over the entire surface of the free magnetic layer from the antiferromagnetic layer. Thus, unidirectional anisotropy can be stably imparted to the free magnetic layer at both ends in the stripe longitudinal direction of the magnetoresistive element. Further, the exchange coupling magnetic field can be uniformly applied over the entire surface of the free magnetic layer by providing the antiferromagnetic layer over the entire surface of the magnetoresistive element. As a result, the strength of the exchange coupling magnetic field can be adjusted in a proper range according to the strength of an estimated external magnetic field, and thus unidirectional anisotropy can be appropriately applied to the free magnetic layer without excessive increase in strength of the exchange coupling magnetic field. Therefore, a decrease in detection sensitivity of the magnetic sensor can be suppressed.

Further, unidirectional anisotropy can be more stably imparted by providing the hard bias layers at both ends in the stripe longitudinal direction. In addition, unidirectional anisotropy can be particularly stably imparted to the free magnetic layer by providing a plurality of permanent magnet portions between a plurality of element portions in the stripe longitudinal direction of the magnetoresistive element. In this case, even when the hard bias magnetic field from the hard bias layers is locally dispersed by applying a large external magnetic field, unidirectional anisotropy can be stably imparted to the free magnetic layer because the exchange coupling magnetic field is applied to the free magnetic layer from the antiferromagnetic layer, thereby suppressing dispersion of magnetization in the free magnetic layer. Therefore, hysteresis of the magnetoresistive element can be decreased.

In the method for manufacturing the magnetic sensor according to the above-described embodiment, the exchange coupling magnetic field is generated by heat treatment in no magnetic field under a condition in which the hard bias magnetic field is applied to the free magnetic layer from the hard bias layers. In this way, since heat treatment is performed under a condition in which the hard bias magnetic field is applied to the free magnetic layer from the hard bias layers, the magnetization direction of the free magnetic layer is aligned by the shape anisotropy and the hard bias magnetic field from the hard bias layers, and thus the uniform exchange coupling magnetic field can be generated even by heat treatment in no magnetic field. The exchange coupling magnetic field may be generated by heat treatment in a magnetic field. Also, the magnetoresistive element can be manufactured without the need for a heat treatment apparatus in an expensive magnetic field, and thus manufacturing cost can be decreased.

In the method for manufacturing the magnetic sensor according to the above-described embodiment, in the heat treatment step (reflowing step), the free magnetic layer and the antiferromagnetic layer are heated under a condition in which the hard bias magnetic field is applied from the hard bias layers, and thus deterioration in the exchange coupling magnetic field applied to the free magnetic layer from the antiferromagnetic layer can be suppressed. Further, in the method for manufacturing the magnetic sensor according to the above-described embodiment, the pinned magnetic layer is formed without using an antiferromagnetic material, and thus heat treatment in a magnetic field for forming the pinned magnetic layer is not required. Therefore, only heat treatment in no magnetic field may be performed for generating the exchange coupling magnetic field in the free magnetic layer, thereby permitting both the suppression of magnetization dispersion in the pinned magnetic layer and the application of the uniform exchange coupling magnetic field.

(Second Embodiment)

Next, an example of application of the magnetic sensor 1 according to the above- described embodiment is described. Although, in a description below, application of the magnetic sensor 1 according to the present invention to a magnetic balance- type current sensor is described, the magnetic sensor 1 according to the present invention is not limited to this and can be applied to other apparatuses.

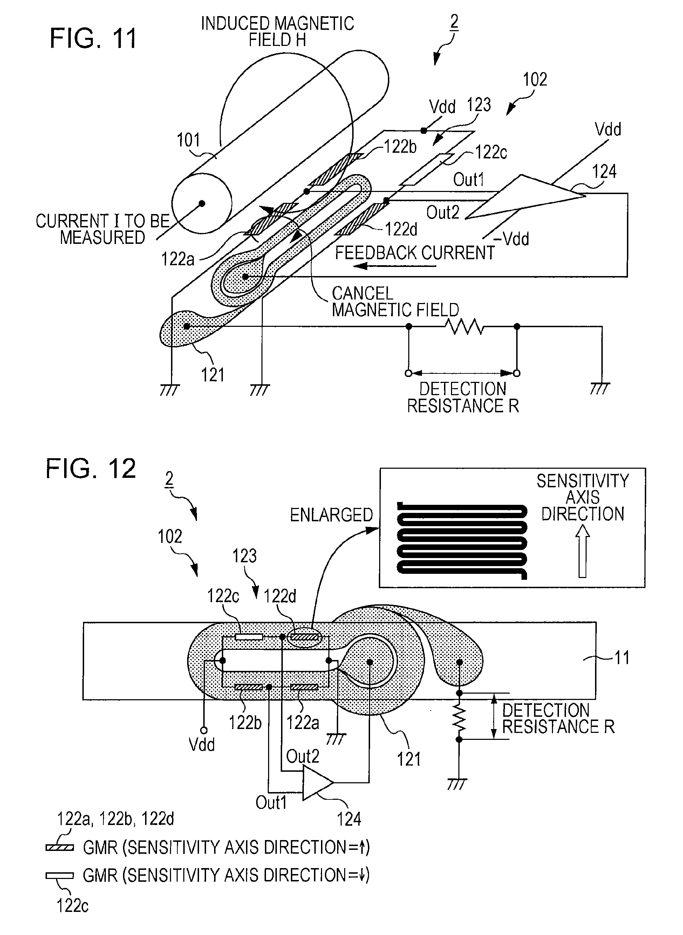

Fig. 11 is a schematic perspective view of a magnetic balance-type current sensor 2 according to a second embodiment of the present invention, and Fig. 12 is a schematic plan view of the magnetic balance-type current sensor 2 according to the second embodiment.

As shown in Figs. 11 and 12, the magnetic balance-type current sensor 2 according to the second embodiment is disposed near a conductor 101 in which a current I to be measured flows. The magnetic balance-type current sensor 2 includes a feedback circuit 102 which generates a magnetic field (cancel magnetic field) that cancels an induced magnetic field H from the current I to be measured flowing in the conductor 101. The feedback circuit 102 includes a feedback coil 121 wound in a direction in which the magnetic field produced by the current I to be measured is canceled, and four magnetoresistive elements 122a to 122d.

The feedback coil 121 is composed of a planar coil. In this configuration, the feedback coil 121 can be formed at low cost because a magnetic core is absent. Also, in comparison with a toroidal coil, the cancel magnetic field produced from the feedback coil 121 can be prevented from extending in a wide range and thus can be avoided from influencing peripheral circuits. Further, in comparison with a toroidal coil, when the current I to be measures is an alternating current, the cancel magnetic field of the feedback coil 121 can be easily controlled, and a current caused to flow for control is not so large. These effects are increased when the current I to be measure is an alternating current and has a higher frequency. In the case of the feedback coil 121 composed of a planar coil, the planar coil is preferably provided to produce both the induced magnetic field H and the cancel magnetic field within a plane parallel to the formation plane of the planar coil.

The magnetoresistive elements 122a to 122d are changed in resistance value in response t the induced magnetic field H applied from the current I to be measured. The four magnetoresistive elements 122a to 122d constitute a magnetic-field detection bridge circuit 123. By using the magnetic-field detection bridge circuit 123 having the magnetoresistive elements 122a to 122d, the magnetic balance-type current sensor 2 with high sensitivity can be realized.

The magnetic-field detection bridge circuit 123 has two outputs which produce a voltage difference according to the induced magnetic field H generated from the current I to be measured. In the magnetic-field detection bridge circuit 123 shown in Fig. 12, a power supply Vdd is connected to a connection point between the magnetoresistive element 122b and the magnetoresistive element 122c, and a ground (GND) is connected to a connection point between the magnetoresistive element 122a and the magnetoresistive element 122d. Further, in the magnetic-field detection bridge circuit 123, one (Out1) of the outputs is taken out from the connection point between the magnetoresistive elements 122a and 122b, and the other output (Out2) is taken out from the connection point between the magnetoresistive elements 122c and 122d. These two outputs are amplified by an amplifier 124 and supplied as a current (feedback current) to the feedback coil 121. The feedback current corresponds to the voltage difference according to the induced magnetic field H. In this case, the cancel magnetic field that cancels out the induced magnetic field H is produced in the feedback coil 121. The current I to be measured is measured with a detection portion (detection resistance R) on the basis of a current flowing through the feedback coil 121 when a balanced state is reached in which the induced magnetic field H and the cancel magnetic field are canceled out by each other.

As shown in an enlarged view of Fig. 12, each of the magnetoresistive elements 122a to 122d preferably has a folded shape (meandering shape) in which a plurality of stripe-shaped elongated patterns (stripes) are arranged so that the longitudinal directions are parallel to each other. In the meandering shape, the sensitivity axis direction (Pin direction) is a direction (stripe width direction D2 (refer to Fig. 1)) perpendicular to the longitudinal direction (stripe longitudinal direction D1 (refer to Fig. 1)) of the elongated patterns. In the meandering shape, the induced magnetic field H and the cancel magnetic field are applied along the stripe width direction D2 perpendicular to the stripe longitudinal direction D1.

In the magnetic balance-type current sensor 2 having the above-described configuration, as shown in Fig. 11, the magnetoresistive elements 122a to 122d receive the induced magnetic field produced from the current I to be measured, and feed back the induced magnetic field H to generate the cancel magnetic field from the feedback coil 121, and the magnetic field to be applied to the magnetoresistive elements 122a to 122d is appropriately adjusted to be zero by canceling out the two magnetic fields (induced magnetic field H and cancel magnetic field) by each other.

The magnetic balance-type current sensor 2 having the above-described configuration preferably uses the magnetic-field detection bridge circuit 123 including the magnetoresistive elements 122a to 122d as magnetic detection elements, particularly GMR (Giant Magneto Resistance) elements or TMR (Tunnel Magneto Resistance) elements. This can realize the magnetic balance-type current sensor 2 with high sensitivity. Also, in the magnetic balance-type current sensor 2, the magnetic-field detection bridge circuit 123 includes the four magnetoresistive elements 122a to 122d having the same film structure. In addition, the magnetic balance-type current sensor 2 having the above-described configuration includes the feedback coil 121 and the magnetic-field detection bridge circuit 123 which are formed on the same substrate, thereby permitting an attempt to reduce the size. Further, the magnetic balance-type current sensor 2 has a configuration without a magnetic core, thereby permitting an attempt to reduce the size and cost.

In the magnetic balance-type current sensor 2 having the four magnetoresistive elements 122a to 122d arranged as described above, the cancel magnetic field is applied to the magnetoresistive elements 122a to 122d from the feedback coil 121 so that a voltage difference between the two outputs (Out1 and Out2) of the magnetic-field detection bridge circuit 123 is zero, and, in this state, the current I to be measured is measured by detecting a current flowing through the feedback coil 121.

The magnetic sensor according to the present invention can be applied to a magnetic balance-type current sensor having a magnetic-field detection bridge circuit including at least one magnetoresistive element in which a resistance value is changed by applying an induced magnetic field from a current to be measured, the current to be measured being measured based on a voltage difference output from the magnetic-field detection bridge circuit according to the induced magnetic field from the current to be measured. In this case, the magnetic sensor according to the present invention has a laminated structure including a ferromagnetic pinned layer having a pinned magnetization direction, a nonmagnetic intermediate layer, a free magnetic layer with a magnetization direction which varies with an external magnetic field, and an antiferromagnetic layer which applies an exchange coupling magnetic field to the free magnetic layer. By using the magnetic sensor, the magnetic balance-type current sensor having high measurement accuracy over a wide range and being capable of decreasing dispersion of the magnetization direction of a free magnetic layer of a magnetoresistive element can be realized.

The present invention is not limited to the above-described embodiments, and can be carried out with various modifications. For example, the materials, connection relation, thicknesses, sizes, manufacturing methods, etc. of the elements of the embodiments can be properly changed. In addition, appropriate modifications can be made without deviating from the scope of the present invention.

Industrial Applicability

The present invention has the effect of decreasing dispersion of the magnetization direction of a free magnetic layer in a magnetoresistive element and achieving high measurement accuracy over a wide range, and particularly can be applied to various magnetic sensors and current sensors which detect the magnitude of a current for driving electric automobile motors.

The present application is based on Japanese Application No. 2010-280498 filed December 16, 2010. The entire contents are incorporated herein.

**Claims**

1.  A magnetic sensor comprising a magnetoresistive element having a sensitivity axis in a specified direction, wherein the magnetoresistive element has a laminated structure including a ferromagnetic pinned layer having a pinned magnetization direction, a nonmagnetic intermediate layer, a free magnetic layer having a magnetization direction varying with an external magnetic field, and an antiferromagnetic layer which applies an exchange coupling magnetic field to the free magnetic layer.

2.  The magnetic sensor according to Claim 1, wherein the ferromagnetic pinned layer is a self-pinned type including a first ferromagnetic film and a second ferromagnetic film which are antiferromagnetically coupled to each other through an antiparallel coupling film, and the first ferromagnetic film and the second ferromagnetic film have substantially the same Curie temperature and a difference in magnetization amount of substantially zero.

3.  The magnetic sensor according to Claim 1 or 2, wherein the magnetoresistive element includes an element portion having a folded shape in which a plurality of stripe-shaped elongated patterns are arranged so that the longitudinal directions of stripe shapes are parallel to each other, and permanent magnet portions provided to hold the element portion therebetween.

4.  The magnetic sensor according to any one of Claims 1 to 3, wherein the magnetoresistive element includes a plurality of element portions provided apart from each other in the longitudinal direction of the stripe shapes, and a plurality of permanent magnet portions provided between the element portions.

5.  The magnetic sensor according to any one of Claims 1 to 4, wherein the ferromagnetic pinned layer has a magnetization direction pinned along a direction in which an external magnetic field is applied, and the free magnetic layer is magnetized in a direction substantially perpendicular to the direction in which the external magnetic field is applied.

6.  The magnetic sensor according to any one of Claims 1 to 5, wherein the first ferromagnetic film is composed of a CoFe alloy containing 40 atomic % to 80 atomic % of Fe, and the second ferromagnetic film is composed of a CoFe alloy containing 0 atomic % to 40 atomic % of Fe.

7.   The magnetic sensor according to any one of Claims 1 to 6, wherein the antiferromagnetic layer is laminated on a surface of the free magnetic layer opposite to the surface on which the nonmagnetic intermediate layer is formed, and the antiferromagnetic layer is composed of an antiferromagnetic material containing element X (X is at least one element of Pt, Pd, Ir, Rh, Ru, and Os) and Mn.

8.  A magnetic proportional current sensor comprising a magnetic-field detection bridge circuit which includes at least one magnetoresistive element varying in resistance value with an induced magnetic field applied from a current to be measured and which has two outputs producing a voltage difference corresponding to the induced magnetic field, the current to be detected being measured by a voltage difference output from the magnetic-field detection bridge circuit according to the induced magnetic field, wherein the magnetoresistive element has a laminated structure including a ferromagnetic pinned layer which has the pinned magnetization direction, a nonmagnetic intermediate layer, a free magnetic layer which has a magnetization direction varying with an external magnetic field, and an antiferromagnetic layer which applies an exchange coupling magnetic field to the free magnetic layer.

9. A magnetic balance-type current sensor comprising a magnetic-field detection bridge circuit which includes at least one magnetoresistive element varying resistance value with an induced magnetic field applied from a current to be measured and which has two outputs producing a voltage difference corresponding to the induced magnetic field, and a feedback coil disposed near the magnetoresistive element and generating a cancel magnetic field for cancelling the induced magnetic field, the current to be measured being measured based on a current flowing through the feedback coil when a balanced state is reached in which the induced magnetic field and the cancel magnetic field are cancelled out by each other by electricity supplied to the feedback coil due to the voltage difference, wherein the magnetoresistive element has a laminated structure including a ferromagnetic pinned layer having the pinned magnetization direction, a nonmagnetic intermediate layer, a free magnetic layer having a magnetization direction varying with an external magnetic field, and an antiferromagnetic layer which applies an exchange coupling magnetic field to the free magnetic layer.

10. A method for manufacturing a magnetic sensor comprising a first deposition step of depositing a ferromagnetic pinned layer by applying a magnetic field in a specified direction, a second deposition step of depositing a free magnetic layer and an antiferromagnetic layer by applying a magnetic field in a direction different from that in the first deposition step to form an element portion, a third deposition step of depositing a permanent magnet layer after patterning the element portion and then patterning the permanent magnet layer, a magnetization step of magnetizing the permanent magnet layer in substantially the same direction as an exchange coupling magnetic field to be applied to the free magnetic layer from the antiferromagnetic layer, and a heat treatment step of performing heat treatment at at least 200°C after magnetization of the permanent magnet layer.

# FIG. 1

# FIG. 2

# FIG. 3

# FIG. 4

## FIG. 5

## FIG. 6

# FIG. 7

# FIG. 8

$$REMANENCE = \{R0(+) - R0(-)\} / \Delta R \times 100 / 2$$

## FIG. 9

## FIG. 10

**FIG. 11**

INDUCED MAGNETIC FIELD H

2

102

101

Vdd  123

122b

Vdd

122c

124

Out1

Out2

CURRENT I TO BE MEASURED

122a

122d

FEEDBACK CURRENT

-Vdd

CANCEL MAGNETIC FIELD

121

DETECTION RESISTANCE R

**FIG. 12**

2

102

123

122c   122d

122b   122a

ENLARGED

SENSITIVITY AXIS DIRECTION

11

Vdd

Out2

Out1

124

121

DETECTION RESISTANCE R

122a, 122b, 122d

GMR (SENSITIVITY AXIS DIRECTION=↑)

GMR (SENSITIVITY AXIS DIRECTION=↓)

122c

# FIG. 13

<table>
<tr><td align="center">**INTERNATIONAL SEARCH REPORT**</td><td colspan="2">International application No.<br>PCT/JP2011/077242</td></tr>
</table>

**A. CLASSIFICATION OF SUBJECT MATTER**
*H01L43/08*(2006.01)i, *G01R15/20*(2006.01)i, *G01R33/09*(2006.01)i

According to International Patent Classification (IPC) or to both national classification and IPC

**B. FIELDS SEARCHED**

Minimum documentation searched (classification system followed by classification symbols)
H01L43/08, G01R15/20, G01R33/09

Documentation searched other than minimum documentation to the extent that such documents are included in the fields searched
Jitsuyo Shinan Koho         1922-1996   Jitsuyo Shinan Toroku Koho   1996-2012
Kokai Jitsuyo Shinan Koho   1971-2012   Toroku Jitsuyo Shinan Koho   1994-2012

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X<br>Y<br>A | JP 2002-304709 A  (Sony Corp.),<br>18 October 2002 (18.10.2002),<br>paragraphs [0017] to [0034]; fig. 2 to 3<br>(Family: none) | 1,7<br>2-6,8,10<br>9 |
| X<br>Y<br>A | JP 2009-38343 A  (Honeywell International Inc.),<br>19 February 2009 (19.02.2009),<br>paragraphs [0016] to [0021]; fig. 1<br>& US 2009/0034321 A1    & EP 2023354 A2 | 1,7<br>2-6,8,10<br>9 |
| Y<br>A | WO 2009/151024 A1  (Alps Electric Co., Ltd.),<br>17 December 2009 (17.12.2009),<br>paragraphs [0011] to [0047]; fig. 1 to 2, 7<br>(Family: none) | 2-6,8,10<br>9 |

☒  Further documents are listed in the continuation of Box C.          ☐   See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>21 February, 2012 (21.02.12) | Date of mailing of the international search report<br>28 February, 2012 (28.02.12) |
|---|---|
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

| International application No. |
|---|
| PCT/JP2011/077242 |

C (Continuation).   DOCUMENTS CONSIDERED TO BE RELEVANT

| Category* | Citation of document, with indication, where appropriate, of the relevant passages | Relevant to claim No. |
|---|---|---|
| P,A | WO 2010/143718 A1 (Alps Green Device Co., Ltd.), 16 December 2010 (16.12.2010), paragraphs [0021] to [0024]; fig. 1 to 2 (Family: none) | 9 |
| A | JP 2003-332649 A (Alps Electric Co., Ltd.), 21 November 2003 (21.11.2003), paragraphs [0046] to [0091]; fig. 1 (Family: none) | 1-10 |

Form PCT/ISA/210 (continuation of second sheet) (July 2009)

**EP 2 654 095 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 11191647 A

- JP 2010280498 A